# EUROPEAN PATENT APPLICATION

(11) **EP 4 746 031 A1**
(43) Date of publication of application: **20.05.2026**
(21) Application number: 25162368.2
(22) Date of filing: 07.03.2025
(51) Int. Cl.: H01L 21/67, H01L 21/673

(54) **METHOD AND DEVICE FOR CLEANING A STORAGE CONTAINER**

(30) Priority: 13.11.2024 EP 24212818
(71) Applicant: Brooks Automation (Germany) GmbH, 78256 Steißlingen (DE)
(72) Inventor: Baumeister, Cornelia, 78647 Trossingen (DE); Beck, Daniel, 78467 Konstanz (DE)
(74) Representative: Dehns Germany Partnerschaft mbB

(57) **Abstract**

The invention relates to a method for cleaning a storage container (100), in particular a storage container for storing semiconductor wafers or lithography masks. The storage container (100) comprises a plurality of walls (112a, 112b, 112c, 112d, 112e) forming a main body (110) of the storage container (100), a loading opening (111) of the main body (100) formed opposite to one of the plurality of walls (112a-e) and formed by the other ones of the plurality of walls (112a-e), wherein at least one first opening (114a, 114b, 114c) is formed on at least one of plurality of walls (112a-e). In the method, the loading opening (111) and the at least one first opening (114a-d, 115a-c) of the storage container (100) are sealed (200) and an outside and/or an inside of the storage container (100) is cleaned (210). To clean (210, 410) the storage container (100), a first cleaning fluid is provided (211, 411) to an inside surface of the storage container (100), or a second cleaning fluid is provided (212, 412) to an outside surface of the storage container (100). The invention further relates to a device (300) for cleaning a storage container (100).

## Description

The present invention relates to a method and a device for cleaning a storage container, in particular a storage container for storing semiconductor wafers, from which semiconductor chips are made, and/or lithography masks, which are used for chip manufacture.

### Background

Front opening unified pods (FOUP) are specialized storage containers designed to hold wafers, in particular semiconductor wafers in a controlled environment. FOUPs are typically used to transport wafers and/or lithography masks between different method steps (manufacturing stages) to prevent the wafers and/or lithography masks from being contaminated. For this purpose, FOUPs provide a controlled environment in which pressure, airflow and particle-content is controlled. Similar requirements exist for transportation or storage containers for lithography masks (often referred to as reticles), e.g. EUV lithography masks,

The controlled environment during transportation of wafers and/or lithography masks is essential for the fabrication of highly integrated electric circuits on the wafers/chips with the lithography mask, as even minor contamination can lead to errors in the electronic circuits on the chips, which can result in a whole batch of chips being unusable, thus reducing the yield, which can for example be defined as the percentage of usable chips per reticle.

However, over time, FOUPs can be contaminated by gases from manufacturing processes or by chemical compounds emitted from the wafers and/or lithography masks stored therein. To flush out ("purge") most of the contamination molecules and/or ions, FOUPs are provided with purge nozzles through which an inert gas can be flushed into the FOUP.

Further, to prevent contamination molecules being transferred from one batch of wafers to another, FOUPs are cleaned regularly, in particular from the inside and the outside.

However, due to the purge gas openings and other openings provided on the FOUP, cleaning fluid, for example cleaning fluid used during the cleaning operation of the FOUP, can be transferred between the outside and the inside of the FOUP, and vice versa This needs to be prevented, especially as the cleaning fluid may be unsuitable and/or contaminated. Also, such cleaning fluid may become trapped in the purge gas openings, which also constitutes a potential source of contamination.

### Summary of the Invention

The present invention addresses these issues by providing a method and a device for cleaning a storage container, in particular a storage container for storing semiconductor wafers and/or lithography masks, comprising the features of the respective independent claims. Advantageous embodiments and additional features are provided in the dependent claims and further discussed in the following description.

The present invention addresses the cleaning of storage containers, in particular a type of storage container for storing wafers or lithography masks, comprising a plurality of walls forming a main body of the storage container. A loading opening of the main body is formed opposite to one of the plurality of walls and defined by the other ones of the plurality of walls. At least one first opening is formed on at least one of the plurality of walls. The first opening can, for example, be provided on a wall of the storage container opposite to a side wall on which a holding flange, configured to hold the storage container, is arranged. An example of this type of storage container is a FOUP (Front Opening Unified Pod).

The first openings can for example be one or more purge gas openings such as a purge gas inlet adapted to engage with a corresponding nozzle of a gas supply system, or a purge gas outlet. These openings are used to purge the interior of the storage container with an inert gas, either when the semiconductor wafers or lithography masks are placed in the storage container, or, when the storage container is empty. For example, purge gas openings typically have a complex structure comprising a plurality of parts or sections, within which cleaning fluid can become trapped during cleaning. Such trapped fluid can constitute a significant source of contamination. To give an example, a purge gas inlet typically comprises several parts/sections, in particular a hydrophobic layer that repels water, a filter layer and a one-way air valve (check valve). The hydrophobic layer is usually installed on an inner side of the storage container and the one-way valve allows gas to travel only from the outside to the inside or from the inside to the outside of the storage container through the filter. The invention is also applicable to another kind of first openings, namely sampling openings, which are, for example, provided in certain types of FOUPs. These samplings openings are used to draw gas samples from the inside of the FOUP, and are similarly designed as the inlet openings described above, with the one-way air valve allowing passage of gas from the inside to the outside of the FOUP.

As laid out above, due to the various types of first openings, unsuitable and/or contaminated cleaning fluid can pass or become trapped between the inside and the outside of the storage container during cleaning, thereby transferring contaminants from the inside and the outside and vice versa, and/or leading to subsequent contamination caused by the trapped cleaning fluid.

To prevent cleaning fluid being trapped in this way as well as such an exchange of contaminants occurring, according to the invention, the method comprises the sealing of the loading opening and the at least one first opening of the storage container. The sealing is particularly provided in such a way that a cleaning fluid cannot be trapped within the various openings and especially cannot be transferred between the inside of the storage container and the outside of the storage container during the cleaning, or vice versa. With such a sealing, the outside and/or the inside of the storage container can effectively be cleaned by providing a first cleaning fluid to an inside surface of the storage container and/or providing a second cleaning fluid to an outside surface of the storage container.

Due to the sealing, passing of cleaning fluid between the outside and the inside of the storage container during cleaning effectively can be prevented. This is especially advantageous in that the outside of a container such as a FOUP is typically more contaminated than the inside, so that cleaning fluid used for the outside is usually correspondingly more contaminated than cleaning fluid used for the inside. The invention can especially ensure that passage of this more contaminated cleaning fluid used for the outside to the inside of the storage container is effectively avoided.

In an embodiment, the undesirable passage of cleaning fluid from the outside to the inside of a storage container can be further minimised by providing different pressures on the outside and the inside of the container. For example, if the outside of the container is being cleaned, the pressure on the inside of the container can be set to be higher than the pressure on the outside of the container, and vice versa.

In an embodiment, sealing the storage container comprises sealing each first opening by providing pressurized gas on and/or around and/or in the vicinity of each first opening. By means of such a pressurized gas, cleaning fluid, can be prevented from contacting the at least one first opening, especially the purge gas openings, or effectively removed from the first opening before it can enter parts/sections of the opening from which it is difficult or impossible to remove. Liquid media, such as cleaning fluid, that comes into contact with the filter of a purge gas opening or enters the one-way valve is hard to remove and can cause fluid to leak from the outside of the storage container to the inside.

The pressurized gas provided at or on, e.g. directed onto, each first opening is in particular provided by a pressurized gas stream, for example a pressurized air stream. The pressurized gas or air stream may provide an air curtain or air knife that prevents cleaning fluid from coming in contact with the first openings, in particular the various sections/layers of the purge gas opening, i.e. the filter and the one-way valve. Further, the pressurized gas or air stream at or on each first opening is in particular provided from an outer side of the storage container, when the outer side of the storage container is cleaned and/or an outer side and/or an inner side of the storage container, when an inner side of the storage container is cleaned. As the innermost layer of the purge gas opening is usually hydrophobic, by pressurizing the purge gas openings (first openings) from the outside in this way, cleaning fluid coming into contact with the various parts of the purge gas opening can be prevented from entering the purge gas openings even if the storage container is cleaned from the inside and pressure is only applied from the outside.

By using pressurized gas or air, in particular a pressurized gas or air stream, to seal purge gas openings during cleaning with cleaning fluids, contaminant transfer can be prevented in an effective manner without having to mechanically seal the purge gas openings.

In an embodiment, the sealing of the at least one first opening further comprises covering at least one, in particular each, of the at least one first openings using at least one covering structure, wherein the covering structure is provided on an inner side of the storage container, when the inner side of the storage container is cleaned or an outer side of the storage container, when an outer side of the storage container is cleaned.

Hereby, all first openings can be mechanically sealed and cleaning fluid containing contaminants can be prevented from being exchanged between the inside and the outside of the storage container.

In an embodiment, sealing the storage container further comprises detachably connecting the main body of the storage container on a device for cleaning a storage container such that the loading opening of the storage container is sealed by the device for cleaning the storage container.

Thereby, the storage container can be cleaned, especially from the inside, without having to close the storage container main body using a lid.

In an embodiment the storage container further comprises a lid configured to cover and seal the loading opening of the main body, wherein the lid comprises at least one second opening. The lid usually comprises a shell with a bottom surface and a top surface between which an opening and closing mechanism for the lid is arranged. To have access to the opening and closing mechanism, for example to perform maintenance and/or repair, and to reduce the weight of the lid, at least one second opening is arranged on the top (outside) surface of the lid. While cleaning the storage container from the outside with the lid attached, or while cleaning the lid on its own, cleaning fluid should be prevented from entering between the bottom surface and top surface, as it is hard if not impossible to remove such cleaning fluid again, and the opening and closing mechanism could be damaged during the attempt. Thus, sealing the storage container further comprises covering the loading opening of the main body with the lid and covering the at least one second opening. In particular, the at least one second opening is covered by a holding structure, in particular an adapter plate of a holding structure, configured to hold the storage container during cleaning.

Thereby, cleaning fluid entering the lid and/or the storage container can effectively be prevented.

The invention further relates to a device for cleaning a storage container, in particular a storage container for storing semiconductor wafers or lithography masks, such as a FOUP, as proposed above. The device comprises an enclosure at least comprising a contact surface on which the main body of the storage container can be placed such that the loading opening faces and is covered by the contact surface, a first cleaning apparatus arranged such that, when the storage container is placed on the contact surface, a first cleaning fluid can be distributed within the inside of the storage container, and a first drain with a first drain opening arranged such that the first cleaning fluid distributed within the inside of the storage container can flow out of the device. The device further comprises a pressurized gas control device configured to, when the storage container is placed inside the enclosure on the contact surface, provide pressurized gas on the at least one first opening of the storage container. The device is in particular configured to perform a method of cleaning according to the embodiments laid out above.

Thereby, the first openings can effectively be prevented from coming in contact with cleaning fluid and thus, transfer of cleaning fluid and contaminants from an inside of the storage container to the outside of the storage container, and vice versa, can effectively be prevented.

In an embodiment, the pressure control device comprises at least one pressurized air nozzle, in particular a number of pressurized air nozzles equal to the number of first openings, configured to provide pressurized air or gas on and/or around and/or in a vicinity of the at least one first opening.

Using nozzles allows to provide pressurized gas or air, in particular an air curtain or knife, on, around and/or in the vicinity of the first openings in an effective and targeted way, providing an effective seal for the first opening and preventing cleaning fluid to be transferred between an inside and an outside of the storage container and vice versa during cleaning.

In an embodiment, the pressurized gas control device is configured to provide pressurized gas to the at least one first opening from an outer side of the storage container, when the storage container is arranged on the contact surface and an outer side of the storage container is being cleaned and to provide pressure to the at least one first opening from an outer side and/or an inner side of the storage container, when the storage container is arranged on the contact surface and an inner side of the storage container is being cleaned.

Thereby, transfer of cleaning fluid between an inside and an outside of the storage container and vice versa during cleaning can, in particular via the first openings, effectively be prevented.

In an embodiment the device further comprises a second cleaning apparatus arranged such that, when the storage container is placed on the contact surface, a second cleaning fluid can be distributed to the outside of the storage container, and a second drain with a second drain opening arranged such that the second cleaning fluid distributed to the outside of the storage container can flow out of the device.

Thereby, a device for cleaning an inside and an outside of a storage container can be provided in a reliable and effective manner.

In an embodiment, the device further comprises a locking mechanism configured to detachably connect the main body of the storage container to the contact surface.

Thereby, movement of the storage container during cleaning can be prevented and thus, transfer of cleaning fluid between the inside and the outside of the storage container and vice versa during cleaning can be further prevented.

### Brief description of the drawings

Advantages and further aspects of the invention will now be discussed further with reference to the appended drawings. Herein,
Figure 1 shows a perspective view of a prior art FOUP as a storage container, with which the present invention can be implemented,
Figure 2 shows a flow diagram of a method for cleaning a storage container according to an embodiment of the invention,
Figure 3 shows block diagram of a device for cleaning a storage container according to an embodiment of the invention, and
Figures 4 shows a flow diagram of a method for cleaning a storage container according to another embodiment of the invention.

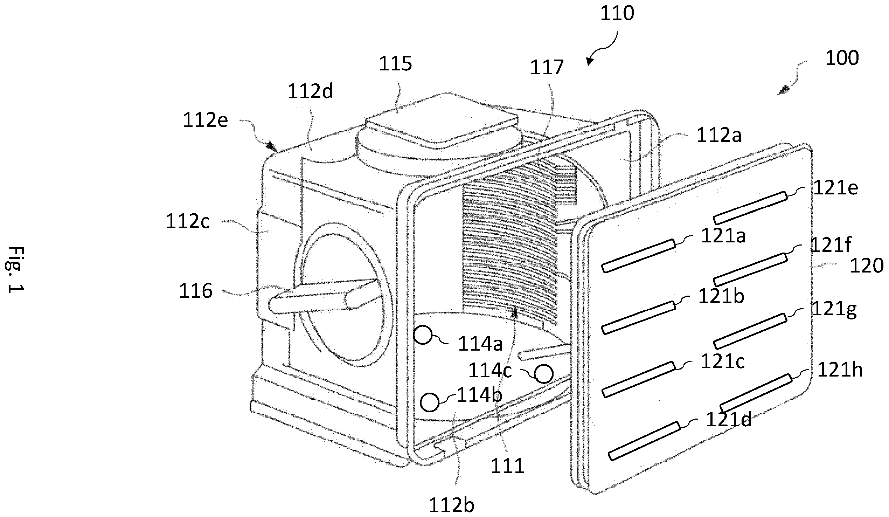

In Figure 1, a perspective view of a prior art FOUP is shown as a typical storage container 100, with which the present invention can be implemented. The FOUP 100 comprises a plurality of walls 112a, 112b, 112c, 112d, 112e forming a box-shaped main body 110 of the FOUP 100 with a loading opening 111. The loading opening 111 is formed opposite to one of the walls, i.e. wall112e, and is formed by the other ones of the walls, i.e. walls 112a-d.

On the inner side of two of the walls 112a, 112c, a supporting structure 117 for supporting semiconductor wafers during transportation is provided. Further, on the outer side of the same walls 112a, 112c, handling members 116 (only one is shown in Fig. 1) are provided. The handling members 116 can be used by human operators to carry the FOUP 100. It is pointed out that the handling members do not have to be on the same walls 112a, 112c as the supporting structure 117, and may be arranged on any two opposite walls.

Further, a handling flange 115 is provided on a top side wall 112d of the FOUP 100. The handling flange 115 is used in case of handling by machines (robots) and devices for handling and transporting the FOUP 100.

Additionally, on the bottom side wall 112b, first openings 114a, 114b, 114c are arranged. The first openings 114a, 114b, 114c can for example be purge gas openings (purge gas inlets and purge gas outlets) used to purge the inside of the storage container 100 with inert gas, for example when the FOUP 100 is loaded with semiconductor wafers or is empty and sealed by a lid 120. While only three first openings 114a, 114b, 114c are shown, the storage container 100 can be provided with more or fewer first openings 114a, 114b, 114c, depending on, for example, purge requirements. Typically, four openings are provided, two of which are provided as purge gas inlets, and two as purge gas outlets.

The FOUP 100 further comprises a lid 120 that usually comprises a bottom surface and a top surface in-between which an opening and closing mechanism (not shown) is arranged

The lid 120 comprises second openings 121a -121h. As mentioned, the lid usually comprises a shell with a bottom surface and a top surface between which an opening and closing mechanism (not shown) for the lid 120 is arranged. To have access to the opening and closing mechanism, for example to perform maintenance and/or repair, and to reduce the weight of the lid 120, the second openings 121a -121h are arranged on the top (outside) surface of the lid 120. While cleaning the FOUP 100 from the outside with the lid 120, or while cleaning the lid 120 on its own, cleaning fluid can enter between the bottom surface and top surface, and it is difficult if not impossible to remove such cleaning fluid again. Also, the opening and closing mechanism could be damaged by contact with such cleaning fluid.

The lid 120 can further be provided with a sealing ring that seals the FOUP 100, when the lid 120 is placed in the loading opening 111.

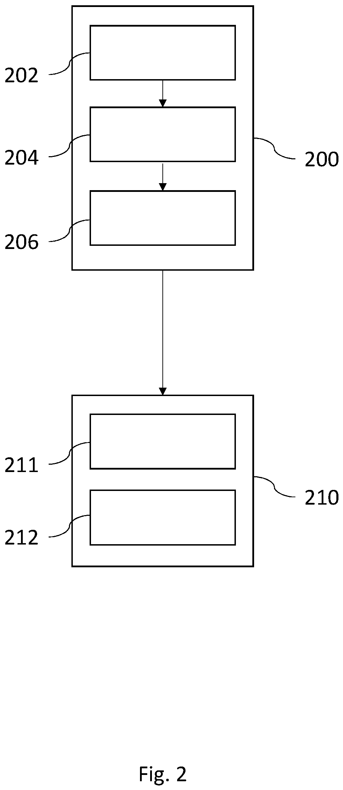

Figure 2 shows a flow diagram of a method for cleaning the storage container 100 according to an embodiment of the invention.

In a block 200, the loading opening 111 and the first openings 114a, 114b, 114c of the FOUP 100 are sealed.

To seal the loading opening 111, in a step 202, the loading opening 111 of the main body 110 is covered with the lid 120.

Further, in a step 204, each of the three first openings 114a, 114b, 114c is sealed using at least one covering structure (not shown). The covering structure is provided on an inner side of the FOUP 100, when the inner side of the FOUP 100 is cleaned or on an outer side of the FOUP 100, when the outer side of the FOUP 100 is cleaned. Pressurized gas, in other words air pressure, can also be applied to the outside of an opening, when the inside of the FOUP is being cleaned, in order to prevent cleaning liquid entering the openings/ports. This is also expedient for FOUPs in which a diffusor, for example comprising a diffusor material, is provided on the inside of an inlet opening in order to optimise distribution of purge gas within the FOUP during purging. By applying pressurized gas to such an opening from the outside, a diffuser material can effectively be kept dry and free from potential contamination, as, for example, fluid can be prevented from entering the diffusor/diffusor material and becoming trapped inside it. In other words, by applying air pressure from the outside towards the inlet openings, the diffuser material may be kept dry during the inside cleaning. It is also possible to achieve this effect of keeping the diffusor material dry by applying air pressure from the inside.

The plurality of second openings 121a-h on the lid 120 is sealed in a step 206 by covering the plurality of second openings 121a-h by a holding structure (also not shown), in particular an adapter plate of a holding structure, configured to hold or at least assist the holding of the FOUP 100 during cleaning.

Subsequently, in a block 210, an outside or an inside of the FOUP 100 is cleaned.

When an inside surface of the FOUP 100 is being cleaned in a step 211, a first cleaning fluid is provided to an inside surface of the FOUP 100 and, when an outside surface of the FOUP 100 is being cleaned in a step 212, a second cleaning fluid is provided to an outside surface of the FOUP 100.

It should be noted that, when the outside of the FOUP 100 is cleaned, the outside of the lid 120 is not cleaned, as it is covered by the holding structure, and can be cleaned in a separate step, if necessary.

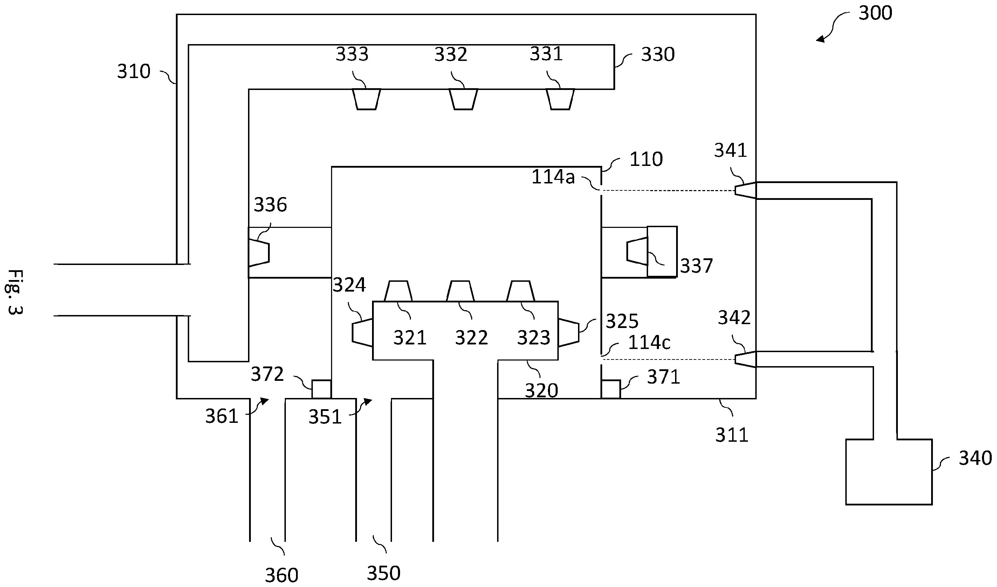

Figure 3 shows a device 300 for cleaning a storage container 100, e.g. a FOUP 100 as described with regard to Figure 1.

The device 300 comprises an enclosure 310 at least comprising a contact surface 311 on which the main body 110 of the storage container 100 can be placed such that the loading opening 111 faces and is covered by the contact surface 311. In the shown embodiment, the device 300 comprises a housing into which the FOUP 100 is placed for cleaning.

The device 300 further comprises a first cleaning apparatus 320 arranged such that, when the FOUP 100 is placed on the contact surface 311, a first cleaning fluid can be distributed within the inside of the FOUP 100. For distribution, the first cleaning apparatus 320 is provided with a plurality of first cleaning fluid nozzles 321, 322, 323 on a cleaning apparatus head. The cleaning apparatus head can be moved transversally, i.e. in an up-and-down direction, and can be rotated to ensure that the whole interior of the main body 110 is cleaned.

Further, the device 300 is provided with a second cleaning apparatus 330 arranged such that, when the FOUP 100 is placed on the contact surface 311, a second cleaning fluid can be distributed to the outside of the FOUP 100. For distribution of the second cleaning fluid, the second cleaning apparatus 330 is provided with a plurality of second cleaning fluid nozzles 331, 332, 333, 334, 335, 336, 337. The second cleaning fluid nozzles 331-337 are arranged such that the second cleaning fluid can be distributed to every side of the main body 110. For this purpose, the direction in which each second cleaning fluid nozzles 331-337 distribute the second cleaning fluid can be changed during cleaning. Alternatively, the second cleaning fluid nozzles 331-337 can be arranged in a movable manner, and for example be provided to perform translational and/or rotational movement..

Thereby, the main body 110 of the FOUP 100 can be cleaned both from the inside and form the outside. It is pointed out that a lid 120 of the FOUP 100 (not shown in Figure 3) may be cleaned at a different location (also not shown).

The device 300 further comprises a first drain 350 with a first drain opening 351 arranged such that the first cleaning fluid distributed to the inside of the FOUP 100 can flow out of the device 300 and a second drain 360 with a second drain opening 361 arranged such that the second cleaning fluid distributed to the outside of the FOUP 100 can flow out of the device 300. Thereby, the used and thus potentially contaminated first and second cleaning fluids can directly flow off.

Further, the device 300 is provided with a pressurized gas control device 340 configured to, when the FOUP 100 is placed inside the enclosure 310 on the contact surface 311, provide pressurized gas, in particular pressurized air, on each first opening 114a, 114b, 114c. For this purpose, the pressure control device 340 comprises pressurized air nozzles 341, 342. In Figure 3, only two pressurized air nozzles 341, 342 are shown. However, due to the arrangement of the first openings 114a, 114b, 114c a third pressurized air nozzle is provided behind one of the two shown pressurized air nozzle 341, 342, i.e. is out of view.

The pressurized gas control device 340 is configured to provide pressurized air to each first opening 114a, 114b, 114c from an outer side of the FOUP 100, when the FOUP 100 is arranged on the contact surface 311 and an outer side or an inner side of the storage container 100 is being cleaned. Thereby, the first openings 114a, 114b, 114c are sealed by an air curtain or air knife and first and/or second cleaning fluid cannot be transferred to the other side of the FOUP 100.

The device 300 further comprises a locking mechanism 371, 372 configured to detachably connect the main body 110 of the FOUP 100 to the contact surface 311. Thereby, movement of the main body 110 during the cleaning is prevented. The locking mechanism 371, 372 can for example be provided as a latch mechanism.

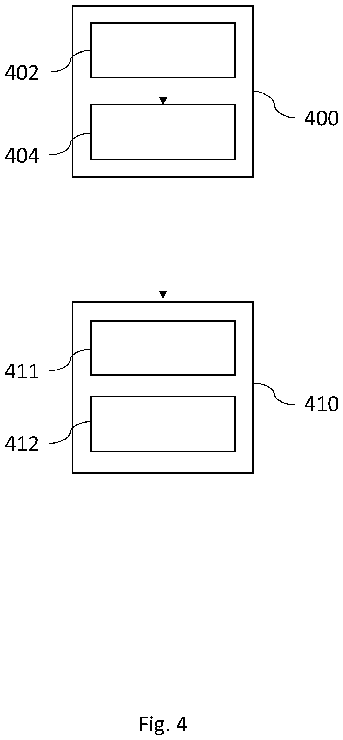

Figure 4 shows a flow diagram of a method for cleaning a storage container 100, in particular a FOUP 100 as shown in Figure 1, according to another embodiment of the invention.

Similar to the method described with regard to the flow diagram in Figure 2, in block 400, the loading opening 111 and the first openings 114a, 114b, 114c are sealed.

To achieve this, in step 402 the main body 110 of the FOUP 100 is detachably connected to the device 300 for cleaning the FOUP 100, e.g. the device 300 as described with regard to Figure 3, such that the loading opening 111 of the FOUP 100 is sealed by the device 300 for cleaning the FOUP 100. To detachably connect the main body 110 to the device 300 locking mechanism 371, 372 is used.

Simultaneously or subsequently, the first openings 114a-c are sealed in a step 404 by providing pressurized gas on the first openings 114a-c. To provide the pressurized gas, the air nozzles 341, 342 of the pressurized gas control device 340 are used. These air nozzles 341, 342 blow pressurized air (shown as dotted lines) onto the first opening 114a, 114b, 114c, forming an air curtain or air knife that prevents first and second cleaning fluid to cross from the inside to the outside of the FOUP 100 and vice versa during cleaning.

In block 410, the inside and/or outside of the storage container 100 is cleaned.

When cleaning the inside of the storage container 100 in step 411, the first cleaning fluid is distributed onto the inside of the main body 110 by the first cleaning apparatus 320.

When cleaning the outside of the storage container 100 in step 412, the second cleaning fluid is distributed onto the inside of the main body 110 by the second cleaning apparatus 330.

In particular, the inside and the outside of the main body 110 of the storage container 100 can be cleaned simultaneously by using device 300.

## Claims

1. Method for cleaning a storage container (100), in particular a storage container for storing semiconductor wafers or lithography masks, the storage container (100) comprising
- a plurality of walls (112a, 112b, 112c, 112d, 112e) forming a main body (110) of the storage container (100),
- a loading opening (111) of the main body (100) formed opposite to one of the plurality of walls (112a-e) and formed by the other ones of the plurality of walls (112a-e),
- wherein at least one first opening (114a, 114b, 114c) is formed on at least one of plurality of walls (112a-e),
the method comprising:
- sealing (200) the loading opening (111) and the at least one first opening (114a-c) of the storage container (100), and
- cleaning (210, 410) an outside and/or an inside of the storage container (100) by:
-- providing (211, 411) a first cleaning fluid to an inside surface of the storage container (100), and/or
-- providing (212, 412) a second cleaning fluid to an outside surface of the storage container (100).

2. Method according to claim 1, wherein sealing (200) the storage container (100) comprises:
-- sealing (404) each first opening (114a-c) by providing pressurized gas on and/or around and/or in the vicinity of each first opening (114a-c).

3. Method according to claim 2, wherein pressurized gas on and/or around and/or in the vicinity of each first opening (114a-c) is provided by a pressurized gas stream.

4. Method according to claim 2 or 3, wherein pressurized gas on and/or around and/or in the vicinity of each first opening (114a-c) is provided from an outer side of the storage container (100), when the outer side of the storage container (100) is cleaned and/or an outer side and/or an inner side of the storage container (100), when an inner side of the storage container (100) is cleaned.

5. Method according to any one of claims 1 to 3, wherein sealing (200) the storage container (100) comprises:
-- covering (204) at least one, in particular each, of the at least one first opening (114a-c) using at least one covering structure, wherein the covering structure is provided on an inner side of the storage container (100), when the inner side of the storage container (100) is cleaned or an outer side of the storage container (100), when an outer side of the storage container (100) is cleaned.

6. Method according any of claims 1 to 5, wherein sealing (200) the storage container (100) comprises:
-- detachably connecting (402) the main body (110) of the storage container (100) to a device (300) for cleaning a storage container (100) such that the loading opening (111) of the storage container (100) is sealed by the device for cleaning the storage container (100).

7. Method according to any of claims 1 to 5, wherein the storage container (100) further comprises a lid (120) configured to cover and seal the loading opening (111) of the main body (110), wherein the lid (120) comprises at least one second opening (121a, 121b, 121c, 121d, 121e, 121f, 121g, 121h), wherein sealing (200) the storage container (100) further comprises:
-- covering (202) the loading opening (111) of the main body (110) with the lid (120),
-- covering (206) the at least one second opening (121a-h).

8. Method according to claim 7, wherein the at least one second opening (121a-h) is covered by a holding structure, in particular an adapter plate of a holding structure, configured to hold the storage container (100) during cleaning (210).

9. Device (300) for cleaning a storage container (100), in particular a storage container for storing semiconductor wafers or lithography masks, the storage container (100) comprising
a plurality of walls (112a, 112b, 112c, 112d, 112e) forming a main body (110) of the storage container (100),
- a loading opening (111) of the main body (100) formed opposite to one of the plurality of walls (112a-e) and formed by the other ones of the plurality of walls (112a-e),
- wherein at least one first opening (114a, 114b, 114c) is formed on at least one of plurality of walls (112a-e),
the device (300) comprising:
- an enclosure (310) at least comprising a contact surface (311) on which the main body (110) of the storage container (100) can be placed such that the loading opening (111) faces and is covered by the contact surface (311),
- a first cleaning apparatus (320) arranged such that, when the storage container (100) is placed on the contact surface (311), a first cleaning fluid can be distributed to the inside of the storage container (100),
- a first drain (350) with a first drain opening (351) arranged such that the first cleaning fluid distributed to the inside of the storage container (100) can flow out of the device (300),
- a pressurized gas control device (340) configured to, when the storage container (100) is placed inside the enclosure (310) on the contact surface (311), provide pressurized gas on and/or around and/or in the vicinity of the at least one first opening (114a-c) of the storage container (100).

10. Device (300) according to claim 9, wherein the pressurized gas control device (340) comprises at least one pressurized air or gas nozzle (341, 342), in particular a number of pressurized air or gas nozzles (341, 342) equal to the number of first openings (141a-c), configured to provide pressurized air or gas on and/or around and/or in a vicinity of the at least one first opening (114a-c).

11. Device according to claim 9 or 10, wherein the pressurized gas control device (340) is configured to provide pressurized air or gas to the at least one first opening (114a-c) from an outer side of the storage container (100), when the storage container (100) is arranged on the contact surface (311) and an outer side of the storage container (100) is being cleaned and to provide pressure to the at least one first opening (114a-c) from an outer side and/or an inner side of the storage container (100), when the storage container (100) is arranged on the contact surface (311) and an inner side of the storage container (100) is being cleaned.

12. Device (300) according to any of claims 9 to 11, wherein the device (300) further comprises:
- a second cleaning apparatus (330) arranged such that, when the storage container (100) is placed on the contact surface (311), a second cleaning fluid can be distributed over the outside of the storage container (100),
- a second drain (360) with a second drain opening (361) arranged such that the second cleaning fluid distributed over the outside of the storage container (100) can flow out of the device (300).

13. Device (300) according to any of claims 9 to 12, wherein the device (300) further comprises a locking mechanism (371, 372) configured to detachably connect the main body (110) of the storage container (100) to the contact surface (311).

14. Device (300) according to any of claims 9 to 13, wherein the device (300) is configured to perform the method steps of any of claims 1 to 6.

15. Device (300) according to any one of claims 9 to 14, wherein the storage container (110) is a FOUP.
